# EUROPEAN PATENT APPLICATION

(11) **EP 4 653 892 A1**
(43) Date of publication of application: **26.11.2025**
(21) Application number: 24747444.8
(22) Date of filing: 24.01.2024
(51) Int. Cl.: G01R 31/374, G01R 31/371, G01R 29/027, G01R 23/00, G01R 31/389, G01R 31/367, G01R 31/396

(54) **BATTERY DIAGNOSIS DEVICE AND BATTERY DIAGNOSIS METHOD**

(30) Priority: 25.01.2023 KR 20230009736
(71) Applicant: LG Energy Solution, Ltd., Seoul 07335 (KR)
(72) Inventor: YOON, Ho Byung, Daejeon 34122 (KR); KANG, Ju Hyun, Daejeon 34122 (KR); LEE, Gyu Yeol, Daejeon 34122 (KR)
(74) Representative: Plasseraud IP
(86) International application number: PCT/KR2024/001138
(87) International publication number: WO 2024/158209

(57) **Abstract**

A battery diagnosis apparatus includes an information obtaining unit configured to receive an output signal from each of a plurality of battery cells of a battery pack to which an alternating-current input signal is applied and a controller configured to compare the output signal with a reference signal to determine whether correction is required, generate a corrected signal by correcting the output signal when correction is required, and determine a state of each of the plurality of battery cells based on characteristics of the corrected signal.

## Description

### [Technical Field]

### CROSS-REFERENCE TO RELATED APPLICATION

This application claims priority to and the benefit of Korean Patent Application No. 10-2023-0009736 filed in the Korean Intellectual Property Office on January 25, 2023, the entire content of which is incorporated herein by reference.

### TECHNICAL FIELD

Embodiments disclosed herein relate to a battery diagnosis apparatus and method.

### [Background Art]

Recently, devices for stably supplying and managing power, such as portable devices like smartphones or laptop computers, electric vehicles or electric kickboards, transport means like electric two-wheel vehicles, and energy storage systems (ESS) have been widely used, interests in batteries are increasing and development of the batteries is becoming more active.

With the spread of devices using batteries, the size of a battery recycling market, etc., as well as a general battery market is increasing. To recycle batteries, it is necessary to accurately diagnose a state of a battery whether the battery can be recycled.

As one of representative techniques for diagnosing batteries, there is a scheme to use electrochemical impedance spectroscopy (EIS) in which a battery is diagnosed using a Nyquist plot with EIS measurement data.

### [Disclosure]

### [Technical Problem]

Embodiments disclosed herein aim to provide an apparatus and method for diagnosing a state of each battery cell.

Technical problems of the embodiments disclosed herein are not limited to the above-described technical problems, and other unmentioned technical problems would be clearly understood by those skilled in the art in the technical field to which the present disclosure pertains from the following description.

### [Technical Solution]

A battery diagnosis apparatus according to an embodiment disclosed herein includes an information obtaining unit configured to receive an output signal from each of a plurality of battery cells of a battery pack to which an alternating-current input signal is applied and a controller configured to compare the output signal with a reference signal to determine whether correction is required, generate a corrected signal by correcting the output signal when correction is required, and determine a state of each of the plurality of battery cells based on characteristics of the corrected signal.

According to an embodiment, the controller may be further configured to compare an amplitude and a phase of the output signal with an amplitude and a phase of the reference signal to determine whether correction is required, and generate the corrected signal by correcting the amplitude or the phase of the output signal when correction is required.

According to an embodiment, the plurality of battery cells may include n battery cells, and the amplitude of the reference signal may correspond to a value obtained by dividing an amplitude of the alternating-current input signal by n, and the phase of the reference signal may correspond to a phase of the alternating-current input signal.

According to an embodiment, the controller may be further configured to correct the amplitude or the phase of the output signal such that the amplitude or the phase of the output signal corresponds to the amplitude or the phase of the reference signal.

According to an embodiment, the controller may be further configured to calculate a frequency-specific impedance response of each of the plurality of battery cells based on the corrected signal.

According to an embodiment, the controller may be further configured to determine the state of each of the plurality of battery cells based on the frequency-specific impedance response.

According to an embodiment, the controller may be further configured to generate a Nyquist diagram based on the frequency-specific impedance response of each of the plurality of battery cells.

According to an embodiment, the controller may be further configured to determine the state of each of the plurality of battery cells by comparing the Nyquist diagram with a reference diagram.

According to an embodiment, the controller may be further configured to compare slopes, X intercepts, or inflection points of the Nyquist diagram and the reference diagram with each other.

According to an embodiment, a sum of the amplitude of the output signal obtained from each of the plurality of battery cells may correspond to an amplitude of the alternating-current input signal applied to the battery pack including the plurality of battery cells.

According to an embodiment, the information obtaining unit may be connected to each battery cell included in the plurality of battery cells.

A battery diagnosis method according to an embodiment disclosed herein includes applying an alternating-current input signal to a plurality of battery cells, receiving an output signal from each of the plurality of battery cells and generating a corrected signal by correcting the output signal, and determining a state of each of the plurality of battery cells, based on characteristics of the corrected signal.

According to an embodiment, the generating of the corrected signal may include comparing an amplitude and a phase of the output signal with an amplitude and a phase of the reference signal to determine whether correction is required, and generating the corrected signal by correcting the amplitude or the phase of the output signal when correction is required.

According to an embodiment, the plurality of battery cells may include n battery cells, and the amplitude of the reference signal may correspond to a value obtained by dividing an amplitude of the alternating-current input signal by n, and the phase of the reference signal may correspond to a phase of the alternating-current input signal.

According to an embodiment, the generating of the corrected signal may include correcting the amplitude or the phase of the output signal such that the amplitude or the phase of the output signal corresponds to the amplitude or the phase of the reference signal.

According to an embodiment, the determining of the state may include calculating a frequency-specific impedance response of each of the plurality of battery cells based on the corrected signal and determining the state of each of the plurality of battery cells based on the frequency-specific impedance response.

According to an embodiment, a sum of the amplitude of the output signal obtained from each of the plurality of battery cells may correspond to an amplitude of the alternating-current input signal applied to the battery pack including the plurality of battery cells.

### [Advantageous Effects]

The battery diagnosis apparatus and the battery diagnosis method according to embodiments disclosed herein may diagnose a state of each of a plurality of battery cells included in a battery pack.

The battery diagnosis apparatus and the battery diagnosis method according to embodiments disclosed herein may diagnose a state of individual cells inside a battery pack without decomposing the battery pack.

### [Description of Drawings]

FIG. 1 illustrates a battery pack according to an embodiment disclosed herein.
FIG. 2 is a view of a battery diagnosis apparatus according to an embodiment disclosed herein.
FIG. 3 illustrates a battery diagnosis apparatus according to another embodiment disclosed herein.
FIG. 4 shows a correction process when an output signal of a battery cell has a normal waveform, according to an embodiment disclosed herein.
FIG. 5 shows a process of correcting an amplitude error of an output signal of a battery cell, according to an embodiment disclosed herein.
FIG. 6 shows a correction process of a phase error of an output signal of a battery cell, according to an embodiment disclosed herein.
FIG. 7 is a diagram of an operating method of a battery diagnosis apparatus according to an embodiment disclosed herein.
FIG. 8 is a flowchart of a battery diagnosis method according to an embodiment disclosed herein.
FIG. 9 illustrates a computing system that executes a battery diagnosis method, according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

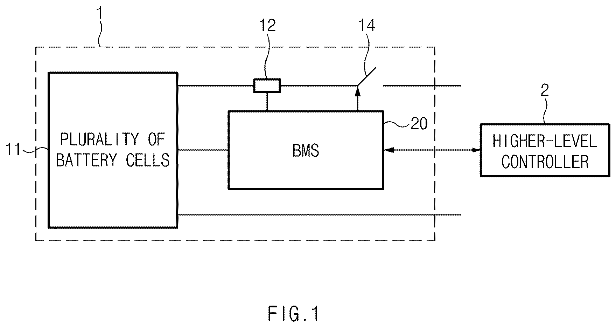

FIG. 1 illustrates a battery pack according to an embodiment disclosed herein.

Referring to FIG. 1, a battery control system including a battery pack 1 and a higher-level controller 2 included in a higher-level system according to an embodiment disclosed herein is schematically shown.

As shown in FIG. 1, the battery pack 1 may include one or more battery cells 11, a switching unit 14 serially connected to a first terminal side and/or a second terminal side of the battery cells 11 to control a charging/discharging current flow of the battery cells 11, and a battery management system 20 for management to prevent over-charging and over-discharging by monitoring a voltage, a current, a temperature, etc., of the battery pack 1.

In this case, the battery pack 1 may include the battery cells 11, the sensor 12, the switching unit 14, and the battery management system 20 provided in plural. For example, the first terminal may be a positive (+) terminal of the battery cells 11, and the second terminal may be a negative (-) terminal.

The battery cells 11 may include a plurality of battery cells. The plurality of battery cells may form one battery pack 1, but the present disclosure is not limited thereto. According to an embodiment, the battery cells 11 may be substantially one battery pack 1. According to another embodiment, the battery cells 11 may be a group of the plurality of battery cells without forming a pack. The plurality of battery cells included in the battery cells 11 may be connected to each other so as to be driven in one unit.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20 may include a plurality of terminals as an interface for receiving measured values of various parameters described above, a circuit connected to the terminals to process received values, etc. The battery management system 20 may control on/off of the switching unit 14, e.g., a relay, a contactor, etc., and may be connected to the battery cells 11 to monitor the state of each battery cell 11.

The higher-level controller 2 may transmit a control signal regarding the battery cells 11 to the battery management system 20. Thus, the battery management system 20 may also be controlled in terms of an operation thereof based on a signal applied from the higher-level controller 2.

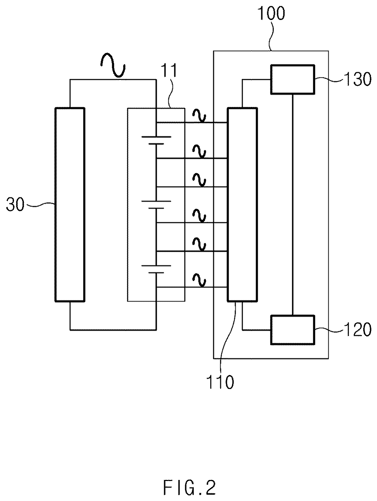

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1.

The battery diagnosis apparatus 100 may diagnose a state of the plurality of battery cells 11. The battery diagnosis apparatus 100 may be connected to each battery cell included in the plurality of battery cells 11. That is, the battery diagnosis apparatus 100 may be directly or indirectly connected to a terminal of each battery cell included in the plurality of battery cells 11.

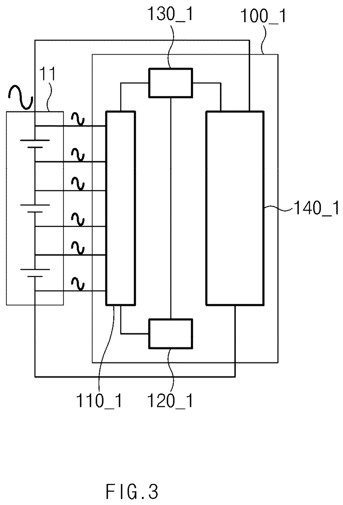

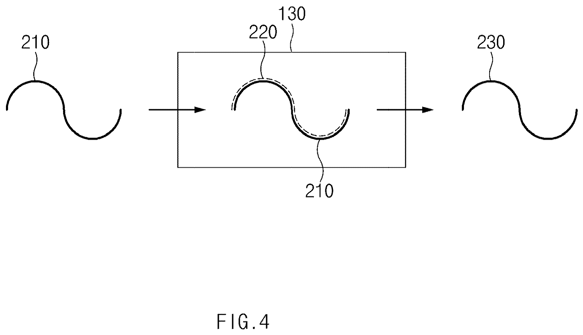

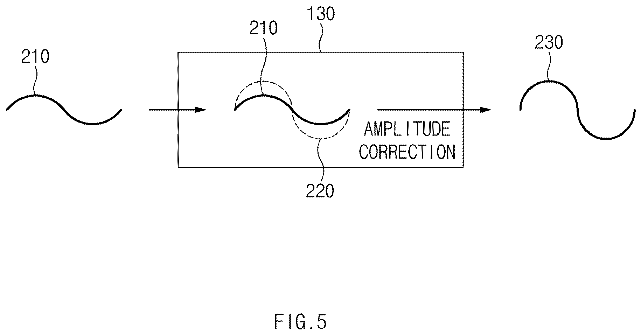

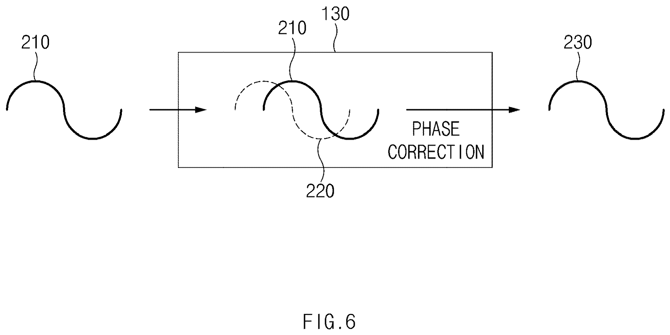

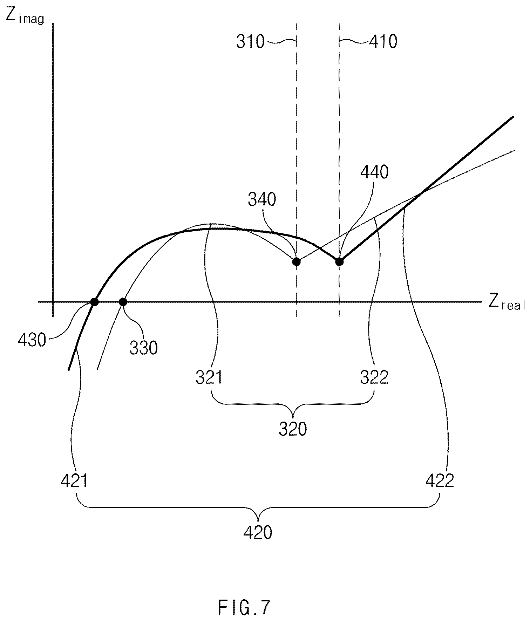

FIG. 2 is a view of a battery diagnosis apparatus according to an embodiment disclosed herein. FIG. 3 illustrates a battery diagnosis apparatus according to another embodiment disclosed herein. FIG. 4 shows a correction process when an output signal of a battery cell has a normal waveform, according to an embodiment disclosed herein. FIG. 5 shows a process of correcting an amplitude error of an output signal of a battery cell, according to an embodiment disclosed herein. FIG. 6 shows a correction process of a phase error of an output signal of a battery cell, according to an embodiment disclosed herein. FIG. 7 is a diagram of an operating method of a battery diagnosis apparatus according to an embodiment disclosed herein.

First, referring to FIG. 2, the battery diagnosis apparatus 100 may include an information obtaining unit 110, a storing unit 120, and a controller 130.

The information obtaining unit 110 may measure a voltage of each battery cell 11. To this end, the information obtaining unit 110 may be connected to each individual cell included in the plurality of battery cells 11. That is, the information obtaining unit 110 may be connected to a first terminal and a second terminal of each battery cell included in the plurality of battery cells 11 to obtain a voltage between the first terminal and the second terminal. Herein, the first terminal may be a (+) terminal, and the second terminal may be a (-) terminal, without being limited thereto. A voltage of each of the battery cells 11 obtained by the information obtaining unit 110 may be defined as an output signal 210.

The storing unit 120 may store the voltage of each of the battery cells 11, obtained by the information obtaining unit 110. That is, the storing unit 120 may receive the output signal 210 from the information obtaining unit 110 and store the output signal 210. According to an embodiment, the storing unit 120 may store not only the output signal 210, but also a reference signal 220 for determining whether to correct the output signal 210 and a correction signal 230 generated by the controller 130. The storing unit 120 may transmit the output signal 210 to the controller 130.

The controller 130 may control a waveform generator 30. The controller 130 may control the waveform generator 30 to apply an alternating-current input signal to the plurality of battery cells 11. That is, the controller 130 may transmit a command for generating the alternating-current input signal to the waveform generator 30 which may then apply the alternating-current input signal to the plurality of battery cells 11 based on the command received from the controller 130. According to an embodiment, the waveform generator 30 may be configured as a separate device from the battery diagnosis apparatus 100, instead of being included in the battery diagnosis apparatus 100. Thus, the controller 130 may be connected to the waveform generator 30 to wirelessly transmit the command for generating the alternating-current input signal to the waveform generator 30 or transmit a command for generating the alternating-current input signal by using wireless communication without separate connection.

The controller 130 may control the waveform generator 30 to control a frequency of the alternating-current input signal applied to the plurality of battery cells 11. According to an embodiment, the controller 130 may control the waveform generator 30 to gradually increase the frequency of the alternating-current input signal applied to the plurality of battery cells 11. As the controller 130 controls the frequency of the alternating-current input signal, the controller 130 may control the frequency of the output signal 210 obtained by the information obtaining unit 110 from the plurality of battery cells 11.

The controller 130 may receive the output signal 210 from the information obtaining unit 110. Herein, the output signal 210 may be a voltage of each battery cell included in the plurality of battery cells 11, such that the controller 130 may receive a voltage of each battery cell included in the plurality of battery cells 11. According to an embodiment, the controller 130 may receive the output signal 210 from the storing unit 120.

The controller 130 may determine whether correction of the output signal 210 is required. That is, the controller 130 may compare the output signal 210 with the reference signal 220 to determine whether correction of the output signal 210 is required. Herein, the controller 130 may determine that correction is not required when the output signal 210 corresponds to the reference signal 220, and determine that correction of the output signal 210 is required when the output signal 210 does not correspond to the reference signal 220. Thus, when correction of the output signal 210 is required, the controller 130 may correct the output signal 210 to generate a corrected signal 230. Thus, when correction of the output signal 210 is not required, the controller 130 may regard the output signal 210 as the corrected signal 230.

Referring to FIG. 3, a battery diagnosis apparatus 100_1 may include an information obtaining unit 110_1, a storing unit 120_1, a controller 130_1, and a waveform generator 140_1. That is, according to various embodiments, the battery management apparatus 100_1 may include the waveform generator 140_1. In this case, the controller 130_1 included in the battery diagnosis apparatus 100_1 may transmit a command for generating an alternating-current input signal to the waveform generator 140_1 in the same apparatus. To this end, the controller 130_1 may control the waveform generator 140_1.

The controller 130_1 may control the waveform generator 140_1 to control a frequency of the alternating-current input signal applied to the plurality of battery cells 11. According to an embodiment, the controller 130_1 may control the waveform generator 140_1 to gradually increase the frequency of the alternating-current input signal applied to the plurality of battery cells 11. As the controller 130_1 controls the frequency of the alternating-current input signal, the controller 130_1 may control the frequency of the output signal 210 obtained by the information obtaining unit 110_1 from the plurality of battery cells 11.

That is, the battery diagnosis apparatus 100_1 according to an embodiment of FIG. 3 may be substantially the same as the battery diagnosis apparatus 100 according to an embodiment of FIG. 2 except for including the waveform generator 140_1. Hereinbelow, for convenience of a description, the description will be made assuming that the battery diagnosis apparatus 100 and the waveform generator 30 are configured as separate devices as shown in FIG. 2.

Referring to FIG. 4, the controller 130 may receive the output signal 210 from the information obtaining unit 110.

The controller 130 may compare the output signal 210 with the reference signal 220. Herein, the reference signal 220 may be defined as a preset signal for checking an error of an amplitude or a phase of the output signal 210.

According to an embodiment, the reference signal 220 may be a signal set arbitrarily by a user to check the error of the amplitude or phase of the output signal 210. For example, the user may define, as the reference signal 220, a signal having a value obtained by dividing the amplitude of the alternating-current input signal by the number of battery cells included in the plurality of battery cells, as the amplitude, and the same phase as the phase of the alternating-current input signal. That is, when the plurality of battery cells 11 includes n battery cells, the amplitude of the reference signal 220 may correspond to a value obtained by dividing the amplitude of the alternating-current input signal by n and the phase of the reference signal 220 may correspond to the phase of the alternating-current input signal. In this case, a sum of the amplitude of the output signal 210 obtained from each of the plurality of battery cells 11 by the information obtaining unit 110 may correspond to the amplitude of the alternating-current input signal applied to the battery pack including the plurality of battery cells 11.

To help understanding, it is assumed that the amplitude of the alternating-current input signal is 100 and the plurality of battery cells 11 includes 100 battery cells. In this case, the amplitude of the reference signal 220 may be 1 obtained by the amplitude of the alternating-current input signal, 100, by the number of battery cells included in the plurality of battery cells 11, 100, and the phase of the reference signal 220 may be the same as the phase of the alternating-current input signal.

Meanwhile, it has been described that the controller 130 configures the reference signal 220 based on the alternating-current input signal, without being limited thereto. According to another embodiment, the amplitude and phase of the reference signal 220 may be those of a preset random signal, separately from the amplitude and the phase of the alternating-current input signal.

The controller 130 may compare the amplitude and the phase of the output signal 210 with the amplitude and the phase of the reference signal 220. For example, the controller 130 may determine that the output signal 210 has a normal waveform, when the amplitude of the output signal 210 is the same as the amplitude of the reference signal 220 and the phase of the output signal 210 is the same as the phase of the reference signal 220. In this case, the controller 130 may determine that correction of the output signal 210 is not required. Thus, the controller 130 may regard the output signal 210 with the corrected signal 230.

According to various embodiments, the controller 130 may determine that the output signal 210 has a normal waveform, not only when the amplitude and the phase of the output signal 210 are the same as the amplitude and the phase of the reference signal 220, but also when the amplitude and the phase of the output signal 210 do not deviate from a preset range of the amplitude and the phase of the reference signal 220. In this regard, the controller 130 may set a range for determining that the output signal 210 has a normal waveform in terms of amplitude and phase. That is, the controller 130 may set a range for determining that the output signal 210 has a normal waveform, taking account of types of a battery pack and a battery cell, the number of battery cells included in the battery pack, and a usage of the battery pack, etc.

Referring to FIG. 5, the controller 130 may correct the amplitude of the output signal 210.

The controller 130 may receive the output signal 210 from the information obtaining unit 110 and compare the output signal 210 with the reference signal 220. In this case, the controller 130 may compare the amplitude of the output signal 210 with the amplitude of the reference signal 220. According to an embodiment, the controller 130 may calculate a ratio of the amplitude of the output signal 210 to the amplitude of the reference signal 220. When the ratio of the amplitude of the output signal 210 to the amplitude of the reference signal 220 exceeds a preset ratio, the controller 130 may determine that the output signal 210 has amplitude abnormality.

When the output signal 210 has amplitude abnormality, the controller 130 may correct the amplitude of the output signal 210. According to an embodiment, the controller 130 may generate the corrected signal 230 by correcting the amplitude of the output signal 210 through multiplication of the output signal 210 by a reciprocal of the ratio of the output signal 210 to the reference signal 220. Thus, the amplitude of the corrected signal 230 generated based on the output signal 210 of each battery cell included in the plurality of battery cells 11 may be corrected to be the same as the amplitude of the reference signal 220.

For convenience of a description, it is assumed that the amplitude of the reference signal 220 is 1 and the amplitude of the output signal 210 is 0.8. The controller 130 may obtain 0.8/1 by calculating the ratio of the output signal 210 to the reference signal 220. In this case, the controller 130 may determine that 0.8/1 exceeds a preset ratio and correct the amplitude of the output signal 210 to 1 by multiplying the amplitude of the output signal 210 by 1/0.8, thereby generating the corrected signal 230. In this way, the controller 130 may correct the amplitude of the corrected signal 230 of each battery cell included in the plurality of battery cells 11 to all 1.

According to various embodiments, the controller 130 may determine whether the output signal 210 has amplitude abnormality based on a difference between the amplitude of the output signal 210 and the amplitude of the reference signal 220.

Referring to FIG. 6, the controller 130 may correct the phase of the output signal 210.

The controller 130 may receive the output signal 210 from the information obtaining unit 110 and compare the output signal 210 with the reference signal 220. In this case, the controller 130 may compare the phase of the output signal 210 with the phase of the reference signal 220.

According to an embodiment, the controller 130 may determine that the output signal 210 has phase abnormality, when a difference between the phase of the output signal 210 and the phase of the reference signal 220 is out of the preset range.

When determining that the output signal 210 has phase abnormality, the controller 130 may correct the phase of the output signal 210. According to an embodiment, the controller 130 may generate a corrected signal 230 by correcting the phase of the output signal 210 such that the phase of the output signal 210 corresponds to the phase of the reference signal 220. Thus, the phase of the corrected signal 230 generated based on the output signal 210 of each battery cell included in the plurality of battery cells 11 may be corrected to be the same as the phase of the reference signal 220.

The controller 130 may repeat the above-described correction of the output signal 210 by adjusting the frequency of the alternating-current input signal. In this way, the controller 130 may obtain the corrected signal 230 of various frequencies.

The controller 130 may calculate a frequency-specific impedance response based on the corrected signal 230 of each battery cell included in the plurality of battery cells 11. According to an embodiment, the controller 130 may calculate an impedance response by using EIS. According to an embodiment, the EIS may be understood as a method of generating a Nyquist diagram 320, based on a result of applying alternating-current power to a battery, and interpreting the same.

More specifically, the controller 130 may identify the impedance response calculated based on the corrected signal 230 of each battery cell included in the plurality of battery cells 11 as a real part Zᵣₑₐₗ and an imaginary part Z_{imag}. The controller 130 may generate an impedance profile based on a real part and an imaginary part of each impedance response. Thus, one impedance profile may include impedance information generated based on the corrected signal 230 of the battery cell according to various frequencies.

Referring to FIG. 7, the controller 130 may generate the Nyquist diagram 320 based on the impedance profile. That is, the controller 130 may represent the frequency of the alternating-current input signal, the real part of the impedance, and the imaginary part of the impedance as one point based on the impedance profile on a coordinate plane having the real part Zᵣₑₐₗ of the impedance response as an X axis and the imaginary part Z_{imag} of the impedance response as a Y axis. Herein, the impedance response at the specific frequency may be shown as a one point on the Nyquist diagram 320. As such, the controller 130 may repeat the same operation on a plurality of frequencies and connect a plurality of points formed in this way, thereby showing one graph.

The controller 130 may determine a state of each of the plurality of battery cells 11 by comparing the Nyquist diagram 320 with a reference diagram 420. The Nyquist diagram 320 generated by the controller 130 may be divided into a second line 321 and a third line 322 with respect to a first line 310. Herein, the first line 310 may be defined as a line drawn perpendicularly to the X axis from an inflection point of the Nyquist diagram 320. The second line 321 may be defined as the Nyquist diagram 320 located in opposition to the X-axis direction with respect to the first line 310. The third line 322 may be defined as the Nyquist diagram 320 located in the X-axis direction with respect to the first line 310.

The reference diagram 420 configured by the controller 130 may be divided into a fifth line 421 and a sixth line 422 with respect to a fourth line 410. Herein, the fourth line 410 may be defined as a line drawn perpendicularly to the X axis from the inflection point of the reference diagram 420. The fifth line 421 may be defined as the reference diagram 420 located in opposition to the X-axis direction with respect to the fourth line 410. The sixth line 422 may be defined as the reference diagram 420 located in the X-axis direction with respect to the fourth line 410.

Hereinbelow, a preset range in each case may be set based on types of the battery pack and the battery cell, the number of battery cells included in the battery pack, the usage of the battery pack, etc.

The controller 130 may compare an X intercept of the Nyquist diagram 320 with an X intercept of the reference diagram 420. The X intercept of the Nyquist diagram 320 may be defined as a first X intercept 330. The reference diagram 420 may be defined as a second X intercept 430. The controller 130 may compare a position of the first X intercept 330 with a position of the second X intercept 430. The controller 130 may determine that a battery cell is defective when the position of the first X intercept 330 deviates from the position of the second X intercept 430 out of a preset range. The first X intercept 330 and the second X intercept 430 respectively mean that impedance is a net real number, and thus in this case, the controller 130 may determine that the battery cell has a problem in internal resistance.

The controller 130 may compare a slope of the third line 322 with a slope of the fifth line 421. The controller 130 may determine that a battery cell is defective when the slope of the third line 322 deviates from the slope of the fifth line 421 out of a preset range. In this case, the controller 130 may determine that there is a problem in a diffusion effect inside the battery cell.

Meanwhile, the inflection point of the Nyquist diagram 320 may be defined as a first inflection point 340. The inflection point of the reference diagram 420 may be defined as a second inflection point 440. The controller 130 may compare a curvature radius of the second line 321 and the first inflection point 340 with a curvature radius of the fifth line 421 and the second inflection point. The controller 130 may determine that a battery cell is defective when the curvature radius of the second line 321 or the position of the first inflection point deviates from the curvature radius of the fifth line 421 or the position of the second inflection point out of a preset range. In this case, the controller 130 may determine that there is a problem in charge transfer in the battery cell.

The controller 130 may determine that the battery cell is normal when the Nyquist diagram 320 corresponds to the reference diagram 420. More specifically, the controller 130 may determine that the battery cell is normal when the position of the first X intercept 330 deviates from the position of the second intercept 430 within a preset range, the slope of the third line 322 deviates from the slope of the fifth line 421 within a preset range, and the curvature radius of the second line 321 and the position of the first inflection point 340 deviate from the curvature radius of the fifth line 421 and the position of the second inflection point 440 within a preset range.

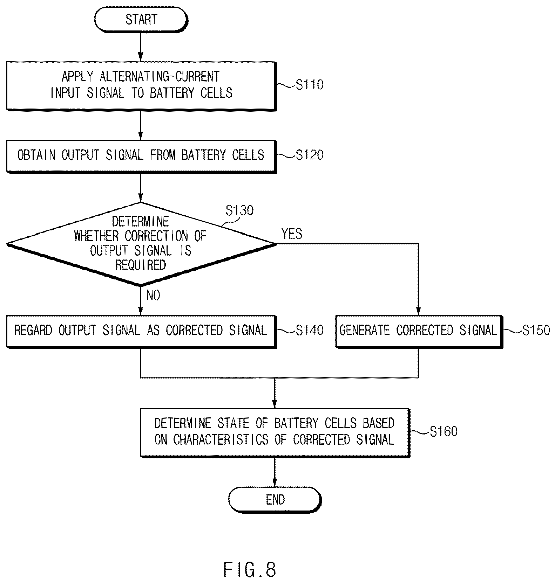

FIG. 8 is a flowchart of a battery diagnosis method according to an embodiment disclosed herein.

The embodiment shown in FIG. 8 may be an example, and an order of operations according to various embodiments of the present disclosure may be different from that shown in FIG. 8, and some operations shown in FIG. 8 may be omitted, the order of the operations may be changed, or the operations may be merged.

Referring to FIG. 8, a battery diagnosis method may include operation S110 of applying an alternating-current input signal to the battery cells 11, operation S120 of obtaining the output signal 210 from the battery cells 11, operation S130 of determining whether correction of the output signal 210 is required, operation S140 of regarding the output signal 210 as the corrected signal 230, operation S150 of generating the corrected signal 230, and operation S160 of determining the state of the battery cells 11 based on characteristics of the corrected signal 230.

Hereinbelow, operations S110 through S160 will be described in detail with reference to FIGS. 1 to 7.

In operation S110, the battery diagnosis apparatus 100 may control the waveform generator to apply the alternating-current input signal to the plurality of battery cells 11. That is, the battery diagnosis apparatus 100 may transmit a command for generating the alternating-current input signal to the waveform generator which may then apply the alternating-current input signal to the plurality of battery cells 11 based on the command received from the battery diagnosis apparatus 100.

The battery diagnosis apparatus 100 may control the waveform generator 30 to control a frequency of the alternating-current input signal applied to the plurality of battery cells 11. According to an embodiment, the battery diagnosis apparatus 100 may control the waveform generator to gradually increase the frequency of the alternating-current input signal applied to the plurality of battery cells 11.

After operation S110, operation S120 may be performed.

In operation S120, the battery diagnosis apparatus 100 may obtain the output signal 210 from the battery cells 11. To this end, the battery diagnosis apparatus 100 may be connected to each individual cell included in the plurality of battery cells 11. That is, the battery diagnosis apparatus 100 may be connected to a first terminal and a second terminal of each battery cell included in the plurality of battery cells 11 to obtain a voltage between the first terminal and the second terminal. Herein, the first terminal may be a (+) terminal, and the second terminal may be a (-) terminal, without being limited thereto. A voltage of each of the battery cells 11 obtained by the battery diagnosis apparatus 100 may be defined as an output signal 210.

After operation S120, operation S130 may be performed.

In operation S130, the battery diagnosis apparatus 100 may determine whether correction of the output signal 210 is required. That is, the battery diagnosis apparatus 100 may compare the output signal 210 with the reference signal 220 to determine whether correction of the output signal 210 is required. Herein, the battery diagnosis apparatus 100 may determine that correction is not required when the output signal 210 corresponds to the reference signal 220, and determine that correction of the output signal 210 is required when the output signal 210 does not correspond to the reference signal 220. More specifically, the battery diagnosis apparatus 100 may compare the amplitude and the phase of the output signal 210 with the amplitude and the phase of the reference signal 220. The battery diagnosis apparatus 100 may determine that the output signal 210 has a normal waveform, when the amplitude of the output signal 210 is the same as the amplitude of the reference signal 220 and the phase of the output signal 210 is the same as the phase of the reference signal 220. In this case, the battery diagnosis apparatus 100 may determine that correction of the output signal 210 is not required. The battery diagnosis apparatus 100 may determine that correction of the output signal 210 is required when the amplitude or phase of the output signal 210 does not correspond to the amplitude or phase of the reference signal 220. When determining that correction of the output signal 210 is not required, the battery diagnosis apparatus 100 may perform operation S140. When determining that correction of the output signal 210 is required, the battery diagnosis apparatus 100 may perform operation S150.

In operation S140, the battery diagnosis apparatus 100 may regard the output signal 210 as the corrected signal 230. That is, the battery diagnosis apparatus 100 may regard the output signal 210 as the corrected signal 230 to regard the output signal 210 as the corrected signal 230 in a determination process based on the corrected signal 230 in a subsequent process, and determine the state of the battery cell based on the output signal 210.

After operation S140, operation S160 may be performed.

In operation 150, the battery heating apparatus 100 may generate the corrected signal 230. The battery diagnosis apparatus 100 may correct the amplitude of the output signal 210 to generate the corrected signal 230. To this end, the battery diagnosis apparatus 100 may compare the amplitude of the output signal 210 with the amplitude of the reference signal 220. According to an embodiment, the battery diagnosis apparatus 100 may calculate a ratio of the amplitude of the output signal 210 to the amplitude of the reference signal 220. When the ratio of the amplitude of the output signal 210 calculated by the battery diagnosis apparatus 100 to the amplitude of the reference signal 220 exceeds a preset ratio, the battery diagnosis apparatus 100 may determine that the output signal 210 has amplitude abnormality. When determining that the output signal 210 has amplitude abnormality, the battery diagnosis apparatus 100 may correct the amplitude of the output signal 210. According to an embodiment, the battery diagnosis apparatus 100 may generate the corrected signal 230 by correcting the amplitude of the output signal 210 through multiplication of the output signal 210 by a reciprocal of the ratio of the output signal 210 to the reference signal 220. Thus, the amplitude of the corrected signal 230 generated based on the output signal 210 of each battery cell included in the plurality of battery cells 11 may be corrected to be the same as the amplitude of the reference signal 220.

The battery diagnosis apparatus 100 may correct the phase of the output signal 210 to generate the corrected signal 230. To this end, the battery diagnosis apparatus 100 may determine that the output signal 210 has phase abnormality, when a difference between the phase of the output signal 210 and the phase of the reference signal 220 is out of the preset range. When determining that the output signal 210 has phase abnormality, the battery diagnosis apparatus 100 may correct the phase of the output signal 210. According to an embodiment, the battery diagnosis apparatus 100 may generate a corrected signal 230 by correcting the phase of the output signal 210 such that the phase of the output signal 210 corresponds to the phase of the reference signal 220. Thus, the phase of the corrected signal 230 generated based on the output signal 210 of each battery cell included in the plurality of battery cells 11 may be corrected to be the same as the phase of the reference signal 220.

After operation S150, operation S160 may be performed.

In operation S160, the battery diagnosis apparatus 100 may determine the state of the battery cells 11 based on characteristics of the corrected signal 230. The battery diagnosis apparatus 100 may calculate a frequency-specific impedance response based on the corrected signal 230 of each battery cell included in the plurality of battery cells 11. According to an embodiment, the battery diagnosis apparatus 100 may calculate an impedance response by using EIS.

More specifically, the battery diagnosis apparatus 100 may generate an impedance profile indicating the impedance response calculated based on the corrected signal 230 of each battery cell included in the plurality of battery cells 11 as correspondence between the real part Zᵣₑₐₗ and the imaginary part Z_{imag}. Thus, one impedance profile may include impedance information generated based on the corrected signal 230 of the battery cell according to various frequencies. That is, the battery diagnosis apparatus 100 may form a pair by correspondence among the frequency of the alternating-current input signal, the real part of the impedance, and the imaginary part of the impedance through the impedance profile.

Referring to FIG. 7, the battery diagnosis apparatus 100 may generate the Nyquist diagram 320 based on the impedance profile. That is, the battery diagnosis apparatus 100 may represent the frequency of the alternating-current input signal, the real part of the impedance, and the imaginary part of the impedance as one point based on the impedance profile on a coordinate plane having the real part Zᵣₑₐₗ of the impedance response as an X axis and the imaginary part Z_{imag} of the impedance response as a Y axis. Herein, the impedance response at the specific frequency may be shown as a one point on the Nyquist diagram 320. As such, the battery diagnosis apparatus 100 may repeat the same operation on a plurality of frequencies and connect a plurality of points formed in this way, thereby showing one graph.

The battery diagnosis apparatus 100 may determine a state of each of the plurality of battery cells 11 by comparing the Nyquist diagram 320 with a reference diagram. The Nyquist diagram 320 generated by the battery diagnosis apparatus 100 may be divided into the second line 321 and the third line 322 with respect to the first line 310.

The battery diagnosis apparatus 100 may compare an X intercept of the second line 321 with an X intercept of the reference diagram. The battery diagnosis apparatus 100 may compare the position of the X intercept of the second line 321 with the position of the X intercept of the reference diagram. The battery diagnosis apparatus 100 may determine that a battery cell is defective when the position of the X intercept of the second line 321 deviates from the position of the X intercept of the reference diagram out of a preset range. The X intercept of the Nyquist diagram 320 means that impedance is a net real number, and thus in this case, the battery diagnosis apparatus 100 may determine that the battery cell has a problem in internal resistance.

The battery diagnosis apparatus 100 may compare a slope of the third line 322 with a slope of a part corresponding to the third line 322 in the reference diagram. The battery diagnosis apparatus 100 may determine that a battery cell is defective when the slope of the third line 322 deviates from the slope of a part corresponding to the third line 322 in the reference diagram, out of a preset range. In this case, the battery diagnosis apparatus 100 may determine that there is a problem in a diffusion effect inside the battery cell.

The battery diagnosis apparatus 100 may compare a curvature radius of the second line 321 and an inflection point of the Nyquist diagram 320 with a curvature radius and an inflection point of a part corresponding to the second line 321 in the reference diagram. The battery diagnosis apparatus 100 may determine that a battery cell is defective when the curvature radius of the second line 321 or the position of the inflection point of the Nyquist diagram 320 deviates from the curvature radius or the inflection point of a part corresponding to the second line 321 in the reference diagram, out of a preset range. In this case, the battery diagnosis apparatus 100 may determine that there is a problem in charge transfer in the battery cell.

The battery diagnosis apparatus 100 may determine that the battery cell is normal when the Nyquist diagram 320 corresponds to the reference diagram 420. More specifically, the battery diagnosis apparatus 100 may determine that the battery cell is normal when the position of the first X intercept 330 deviates from the position of the second intercept 430 within a preset range, the slope of the third line 322 deviates from the slope of the fifth line 421 within a preset range, and the curvature radius of the second line 321 and the position of the first inflection point 340 deviate from the curvature radius of the fifth line 421 and the position of the second inflection point 440 within a preset range.

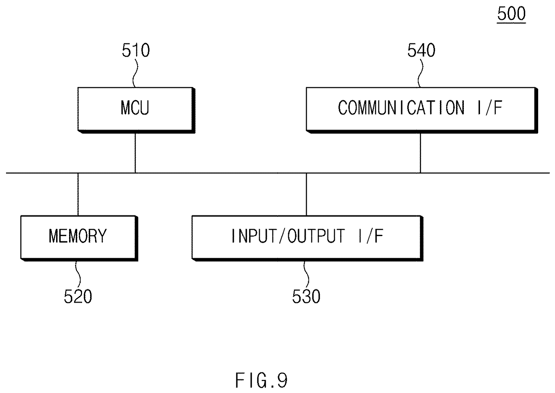

FIG. 9 illustrates a computing system that executes a battery diagnosis method, according to an embodiment disclosed herein.

Referring to FIG. 8, a computing system 500 according to an embodiment disclosed herein may include an MCU 510, a memory 520, an input/output I/F 530, and a communication I/F 540.

The MCU 510 may be a processor that executes various programs (e.g., an SOH calculation program, a cell balancing target determination program, etc.) stored in the memory 520, processes various data including an SOC, an SOH, etc., of the plurality of battery cells 11 through these programs, and executes the above-described functions of the battery diagnosis apparatus 100 described with reference to FIGS. 1 to 7.

The memory 520 may store various programs regarding SOH calculation of the battery cells 11, cell balancing target determination, etc. Moreover, the memory 520 may store various data such as SOC data, SOH data, etc., of each battery cell 11.

The memory 520 may be provided in plural, depending on a need. The memory 520 may be volatile memory or non-volatile memory. For the memory 520 as the volatile memory, random access memory (RAM), dynamic RAM (DRAM), static RAM (SRAM), etc., may be used. For the memory 520 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 520 are merely examples and are not limited thereto.

The input/output I/F 530 may provide an interface for transmitting and receiving data by connecting an input device (not shown) such as a keyboard, a mouse, a touch panel, etc., and an output device such as a display (not shown), etc., to the MCU 510.

The communication I/F 540, which is a component capable of transmitting and receiving various data to and from a server, may be various devices capable of supporting wired or wireless communication. For example, a program for SOH calculation of the battery cells 11 or balancing target determination or various data, etc., may be transmitted and received to and from a separately provided external server through the communication I/F 540.

As such, the battery diagnosis method according to an embodiment disclosed herein may be recorded in the memory 520 and executed by the MCU 510.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery diagnosis apparatus comprising:
an information obtaining unit configured to receive an output signal from each of a plurality of battery cells of a battery pack to which an alternating-current input signal is applied; and
a controller configured to compare the output signal with a reference signal to determine whether correction is required, generate a corrected signal by correcting the output signal when correction is required, and determine a state of each of the plurality of battery cells based on characteristics of the corrected signal.

2. The battery diagnosis apparatus of claim 1, wherein the controller is further configured to compare an amplitude and a phase of the output signal with an amplitude and a phase of the reference signal to determine whether correction is required, and generate the corrected signal by correcting the amplitude or the phase of the output signal when correction is required.

3. The battery diagnosis apparatus of claim 2, wherein the plurality of battery cells comprise n battery cells, and the amplitude of the reference signal corresponds to a value obtained by dividing an amplitude of the alternating-current input signal by n, and the phase of the reference signal corresponds to a phase of the alternating-current input signal.

4. The battery diagnosis apparatus of claim 3, wherein the controller is further configured to correct the amplitude or the phase of the output signal such that the amplitude or the phase of the output signal corresponds to the amplitude or the phase of the reference signal.

5. The battery diagnosis apparatus of claim 1, wherein the controller is further configured to calculate a frequency-specific impedance response of each of the plurality of battery cells based on the corrected signal.

6. The battery diagnosis apparatus of claim 5, wherein the controller is further configured to determine the state of each of the plurality of battery cells based on the frequency-specific impedance response.

7. The battery diagnosis apparatus of claim 5, wherein the controller is further configured to generate a Nyquist diagram based on the frequency-specific impedance response of each of the plurality of battery cells.

8. The battery diagnosis apparatus of claim 7, wherein the controller is further configured to determine the state of each of the plurality of battery cells by comparing the Nyquist diagram with a reference diagram.

9. The battery diagnosis apparatus of claim 8, wherein the controller is further configured to compare slopes, X intercepts, or inflection points of the Nyquist diagram and the reference diagram with each other.

10. The battery diagnosis apparatus of claim 1, wherein a sum of the amplitude of the output signal obtained from each of the plurality of battery cells corresponds to an amplitude of the alternating-current input signal applied to the battery pack comprising the plurality of battery cells.

11. The battery diagnosis apparatus of claim 1, wherein the information obtaining unit is connected to each battery cell included in the plurality of battery cells.

12. A battery diagnosis method comprising:
applying an alternating-current input signal to a plurality of battery cells;
receiving an output signal from each of the plurality of battery cells and generating a corrected signal by correcting the output signal; and
determining a state of each of the plurality of battery cells, based on characteristics of the corrected signal.

13. The battery diagnosis method of claim 12, wherein the generating of the corrected signal comprises comparing an amplitude and a phase of the output signal with an amplitude and a phase of the reference signal to determine whether correction is required, and generating the corrected signal by correcting the amplitude or the phase of the output signal when correction is required.

14. The battery diagnosis method of claim 13, wherein the plurality of battery cells comprise n battery cells, and the amplitude of the reference signal corresponds to a value obtained by dividing an amplitude of the alternating-current input signal by n, and the phase of the reference signal corresponds to a phase of the alternating-current input signal.

15. The battery diagnosis method of claim 14, wherein the generating of the corrected signal comprises correcting the amplitude or the phase of the output signal such that the amplitude or the phase of the output signal corresponds to the amplitude or the phase of the reference signal.

16. The battery diagnosis method of claim 12, wherein the determining of the state comprises:
calculating a frequency-specific impedance response of each of the plurality of battery cells based on the corrected signal; and
determining the state of each of the plurality of battery cells based on the frequency-specific impedance response.

17. The battery diagnosis method of claim 12, wherein a sum of the amplitude of the output signal obtained from each of the plurality of battery cells corresponds to an amplitude of the alternating-current input signal applied to the battery pack comprising the plurality of battery cells.
